# EUROPEAN PATENT APPLICATION

(11) **EP 4 148 802 A1**
(43) Date of publication of application: **15.03.2023**
(21) Application number: 22162735.9
(22) Date of filing: 17.03.2022
(51) Int. Cl.: H01L 29/06, H01L 29/08, H01L 29/16, H01L 29/66, H01L 29/775, H01L 29/778, B82Y 10/00

(54) **MULTI BRIDGE CHANNEL FIELD EFFECT TRANSISTOR AND METHOD OF FABRICATING THE SAME**

(30) Priority: 10.09.2021 KR 20210121176
(71) Applicant: Samsung Electronics Co., Ltd., Gyeonggi-do, 16677 (KR)
(72) Inventor: KIM, Changhyun, 16678, Suwon-si, (KR); KIM, Unki, 18448 Hwaseong-si, (KR); JUNG, Alum, 16678, Suwon-si, (KR); BYUN, Kyun-Eun, 16678, Suwon-si, (KR)
(74) Representative: Elkington and Fife LLP

(57) **Abstract**

A multi bridge channel field effect transistor includes a substrate (110), a first source/drain pattern (180) on the substrate, a second source/drain pattern (190) apart from the first source/drain pattern in a first direction on the substrate, a first channel layer (121) and a second channel layer (122), both made of a two-dimensional semiconductor material and disposed between the first source/drain pattern and the second source/drain pattern, first and second barrier layers (GB1, GB2) made of (nanocrystalline) graphene between the channel layers (121, 122) and the source/drain patterns (180, 190), a gate insulating layer (140) surrounding channel layers, and a gate electrode (160) surrounding gate insulating layer (140) around the channel layers (121, 122).

## Description

### FIELD OF THE INVENTION

The present disclosure relates to a multi bridge channel field effect transistor and/or a method of manufacturing the same.

### BACKGROUND OF THE INVENTION

Transistors are semiconductor devices that play an electrical switching role and are used in various integrated circuit devices including memories, driving ICs, logic devices, and the like. In order to increase the degree of integration of an integrated circuit device, a space occupied by a transistor provided therein has been rapidly reduced, so research has been conducted to reduce the size of the transistor while maintaining performance thereof.

When a channel length decreases as the size of the transistor decreases, problems due to a short channel effect may occur. For example, phenomena such as threshold voltage variation, carrier velocity saturation, and deterioration of sub threshold characteristics may occur. Accordingly, a method of overcoming the short channel effect and effectively reducing the channel length has been sought.

For example, in order to improve a current density, a gate all around structure having a multi bridge channel has been developed. However, various process problems may occur in the fabrication of new device structures.

### SUMMARY OF THE INVENTION

Provided are multi bridge channel field effect transistors including a graphene barrier.

Provided are methods of manufacturing a multi bridge channel field effect transistor including a graphene barrier.

However, the disclosure is not limited thereto.

Additional aspects will be set forth in part in the description which follows and, in part, will be apparent from the description, or may be learned by practice of the presented embodiments of the disclosure.

According to an embodiment, a multi bridge channel field effect transistor may include a substrate; a first source/drain pattern on the substrate; a second source/drain pattern apart from the first source/drain pattern in a first direction on the substrate; a first channel layer and a second channel layer between the first source/drain pattern and the second source/drain pattern; a first graphene barrier between the first channel layer and the first source/drain pattern; a gate insulating layer surrounding the first channel layer; a gate electrode surrounding the first channel layer with the gate insulating layer therebetween.

In some embodiments, the first graphene barrier may extend to an area between the second channel layer and the first source/drain pattern.

In some embodiments, the multi bridge channel field effect transistor may further include a second graphene barrier between the first channel layer and the second source/drain pattern.

In some embodiments, the second graphene barrier may extend to an area between the second channel layer and the second source/drain pattern.

In some embodiments, the gate insulating layer may extend along a surface of the first graphene barrier, a surface of the second graphene barrier, a surface of the first channel layer, and a surface of the second channel layer.

In some embodiments, opposite ends of the first channel layer in the first direction , respectively, may directly contact the first graphene barrier and the second graphene barrier, respectively.

In some embodiments, the first source/drain pattern and the second source/drain pattern may include silicon germanium (SiGe).

In some embodiments, the first source/drain pattern and the second source/drain pattern may include an epitaxial layer.

In some embodiments, the first channel layer and the second channel layer may be arranged in a direction perpendicular to an upper surface of the substrate.

In some embodiments, a thickness of the first graphene barrier may be 2 nanometers (nm) or less.

In some embodiments, the first graphene barrier may include nanocrystalline graphene.

According to an embodiment, a method of manufacturing a multi bridge channel field effect transistor may include forming a stacked structure including a plurality of support layers and a plurality of channel layers alternately stacked on a substrate; forming a first graphene barrier on one side of the stacked structure; forming a first source/drain pattern on an opposite side of the stacked structure with respect to the first graphene barrier; selectively removing the plurality of support layers to expose the plurality of channel layers; forming a gate insulating layer on surfaces of the plurality of channel layers; and forming a gate electrode on a surface of the gate insulating layer.

In some embodiments, the selectively removing the plurality of support layers may be performed by a wet etching process using an etching solution or a dry etching process using an etching gas, and the first graphene barrier may be configured to prevent the etching solution or the etching gas from contacting the first source/drain pattern during the selectively removing of the plurality of support layers.

In some embodiments, the method of manufacturing a multi bridge channel field effect transistor may further include forming a second graphene barrier on the other side of the stacked structure opposite the one side of the stacked structure; and forming a second source/drain pattern on the substrate. The second graphene barrier may extend between the second source/drain pattern and the stacked structure. The second graphene barrier may be configured to prevent the etching solution or the etching gas from contacting the second source/drain pattern during the selectively removing the plurality of support layers.

In some embodiments, the method of manufacturing a multi bridge channel field effect transistor may further include forming the gate insulating layer on a surface of the first graphene barrier during the forming the gate insulating layer.

In some embodiments, the first graphene barrier may be formed by performing a chemical vapor deposition process or an atomic layer deposition process.

In some embodiments, the first source/drain pattern and the plurality of channel layers may be separated from each other by the first graphene barrier.

In some embodiments, the first source/drain pattern and the plurality of support layers may include SiGe.

In some embodiments, the forming of the first source/drain pattern may include performing an epitaxial growth process.

In some embodiments, the first graphene barrier may include nanocrystalline graphene.

According to an example embodiment, a multi bridge channel field effect transistor may include a substrate; a first source/drain pattern and a second source/drain pattern spaced apart from each other in a first direction on the substrate; a first graphene barrier on a sidewall of the first source/drain pattern facing a sidewall of the second source/drain pattern; a plurality of channel layers spaced apart from each other over a portion of the substrate between the first graphene barrier and the second source/drain pattern; a gate insulating layer surrounding the plurality of channel layers; and a gate electrode surrounding the plurality of channel layers with the gate insulating layer in between. The gate electrode may be spaced apart from the first graphene barrier and the second source/drain pattern.

In some embodiments, the multi bridge channel field effect transistor may further include a second graphene barrier on the sidewall of the second source/drain pattern facing the sidewall of the first source/drain pattern. The portion of the substrate may be between the first graphene barrier and the second graphene barrier.

In some embodiments, the gate insulating layer may extend along a surface of the first graphene barrier, a surface of the second graphene barrier, and surfaces of the plurality of channel layers.

In some embodiments, opposite ends of the plurality of channel layers may directly contact the first graphene barrier and the second graphene barrier, respectively.

In some embodiments, the first source/drain pattern and the second source/drain pattern may each include silicon germanium (SiGe).

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a perspective view of a multi bridge channel field effect transistor according to an embodiment;
FIG. 2 is a cross-sectional view of the multi bridge channel field effect transistor of FIG. 1 taken along line A-A';
FIG. 3 is a cross-sectional view of the multi bridge channel field effect transistor of FIG. 1 taken along line B-B' of FIG. 1;
FIGS. 4 to 8 are cross-sectional views corresponding to the line A-A' of FIG. 1 for explaining a method of manufacturing the multi bridge channel field effect transistor of FIG. 1; and
FIG. 9 is a block diagram of an electronic device including a multi bridge channel field effect transistor according to an embodiment.

### DETAILED DESCRIPTION

Reference will now be made in detail to embodiments, examples of which are illustrated in the accompanying drawings, wherein like reference numerals refer to like elements throughout. In this regard, embodiments of inventive concepts may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, embodiments will be described in detail with reference to the accompanying drawings. The same reference numerals refer to the same elements throughout. In the drawings, the sizes of constituent elements may be exaggerated for clarity. The embodiments described below are only examples, and thus, it should be understood that the embodiments may be modified in various forms.

For example, when an element is referred to as being "on" or "above" another element, it may be directly on the other element, or intervening elements may also be present.

As used herein, the singular forms "a," "an," and "the" are intended to include the plural forms as well, unless the context clearly indicates otherwise. In addition, it will be understood that when a unit is referred to as "comprising" another element, it does not preclude the possibility that one or more other elements may exist or may be added.

In addition, terms such as "... unit" or the like refer to units that perform at least one function or operation.

Hereinafter, "at least one of a, b, and c" should be understood to include "only a," "only b," "only c," "a and b," "a and c," "b and c," or "a, b, and c".

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

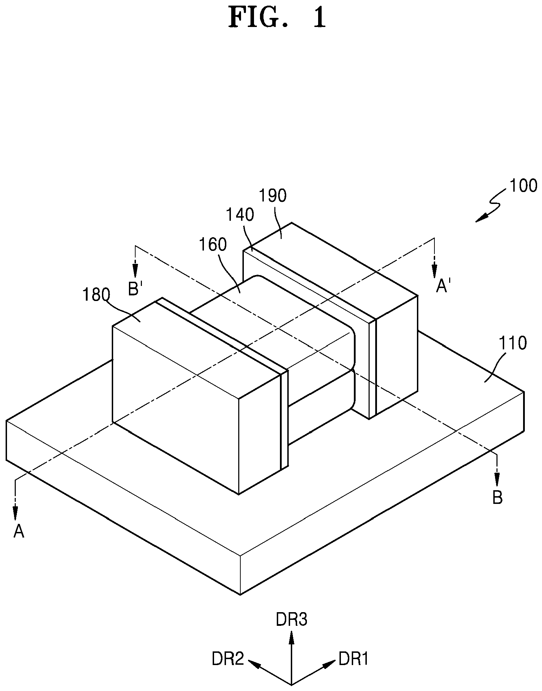

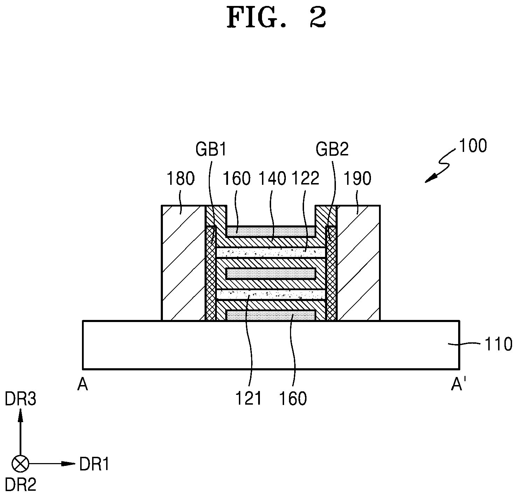

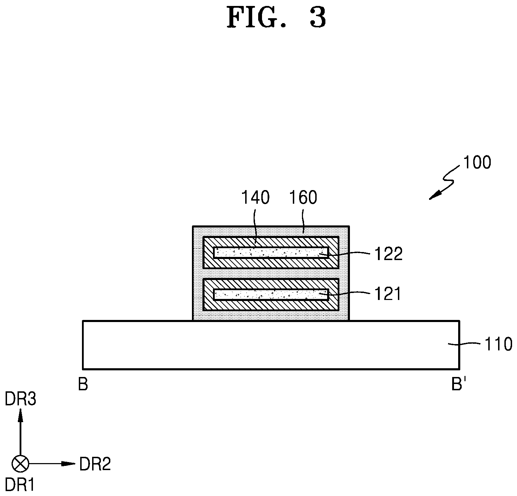

FIG. 1 is a perspective view of a multi bridge channel field effect transistor according to an embodiment. FIG. 2 is a cross-sectional view of the multi bridge channel field effect transistor, taken along line A-A' of FIG. 1. FIG. 3 is a cross-sectional view of the multi bridge channel field effect transistor, taken along line B-B' of FIG. 1.

Referring to FIGS. 1 to 3, a multi bridge channel field effect transistor 100 may be provided. The multi bridge channel field effect transistor 100 may include a substrate 110, a first channel layer 121, a second channel layer 122, a gate insulating layer 140, a gate electrode 160, a source pattern 180, a drain pattern 190, a first graphene barrier GB1, and a second graphene barrier GB2.

The substrate 110 may be an insulating substrate or a semiconductor substrate having an insulating layer formed on its surface. The insulating substrate may be, for example, a glass substrate or a sapphire substrate. The semiconductor substrate may include, for example, silicon (Si), germanium (Ge), silicon germanium (SiGe), or a group III-V semiconductor material. The substrate 110 may be, for example, a silicon substrate having a surface of silicon oxide formed thereon, but is not limited thereto. The substrate 110 may extend in a first direction DR1 and a second direction DR2.

A first source/drain pattern 180 and a second source/drain pattern 190 may be provided on the substrate 110. The second source/drain pattern 190 may be apart from the first source/drain pattern 180 in the first direction. In an example, the first source/drain pattern 180 may be a source of a transistor device, and the second source/drain pattern 190 may be a drain of the transistor device. The first source/drain pattern 180 and the second source/drain pattern 190 may include silicon germanium (SiGe). For example, the first source/drain pattern 180 and the second source/drain pattern 190 may include a SiGe epitaxial layer formed by an epitaxial growth process.

The first channel layer 121 and the second channel layer 122 may be provided between the first source/drain pattern 180 and the second source/drain pattern 190. The first channel layer 121 and the second channel layer 122 may extend in the first direction DR1. The second channel layer 122 may be apart from the first channel layer 121 in the third direction DR3 perpendicular to the upper surface of the substrate 110. The first channel layer 121 and the second channel layer 122 may have a thin thickness. The thickness of the first channel layer 121 and the second channel layer 122 may be the same as that of the first channel layer 121 and the second channel layer 122 in the third direction DR3. For example, the thickness of the first channel layer 121 and the second channel layer 122 may be 10 nanometers (nm) or less. The thickness of the first channel layer 121 and the second channel layer 122 may be determined considering a length of a channel to be formed. The length of the first channel layer 121 and the second channel layer 122 may be 3 nm or less. The first channel layer 121 and the second channel layer 122 may include a semiconductor material. For example, the first channel layer 121 and the second channel layer 122 may include Si or a two-dimensional (2D) semiconductor material. When the first channel layer 121 and the second channel layer 122 include a 2D semiconductor material, the first channel layer 121 and the second channel layer 122 may include at least one of graphene, black phosphorous, and transition metal dichalcogenide (TMD).

Graphene is a material having a hexagonal honeycomb structure in which carbon atoms are two-dimensionally bonded, and has advantages of high electrical mobility and excellent thermal properties, chemical stability, and a large surface area.

Black phosphorus is a substance in which black phosphorus atoms are two-dimensionally bonded.

For example, the TMD may include one of transition metals of molybdenum (Mo), tungsten (W), niobium (Nb), vanadium (V), tantalum (Ta), titanium (Ti), zirconium (Zr), hafnium (Hf), technetium (Tc), and rhenium (Re), and one of chalcogen elements of sulfur (S), selenium (Se), and tellurium (Te). The TMD may be expressed, for example, as MX₂, where M represents a transition metal and X represents a chalcogen element. For example, M may be Mo, W, Nb, V, Ta, Ti, Zr, Hf, Tc, Re, or the like, and X may be S, Se, Te, or the like. Thus, for example, the TDM may include MoS₂, MoSe₂, MoTe₂, WS₂, WSe₂, WTe₂, ZrS₂, ZrSe₂, HfS₂, HfSe₂, NbSe₂, ReSe₂, and the like. Alternatively, the TMD may not be represented by MX₂. In this case, for example, the TMD may include CuS which is a compound of Cu which is a transition metal and S which is a chalcogen element. However, the TMD may be a chalcogenide material including a non-transition metal. The non-transition metal may include, for example, Ga, In, Sn, Ge, Pb or the like. In this case, the TMD may include a non-transition metal such as gallium (Ga), indium (In), tin (Sn), germanium (Ge), and lead (Pb), and a compound of a chalcogen element such as S, Se, or Te. For example, the TMD may include SnSe₂, GaS, GaSe, GaTe, GeSe, In₂Se₃, InSnS₂ or the like. As described above, the TMD is a metal element selected from a group consisting of Mo, W, Nb, V, Ta, Ti, Zr, Hf, Tc, Re, Cu, Ga, In, Sn, Ge, and Pb, and may include one of chalcogen elements of S, Se, and Te. However, the materials described above are merely examples, and other materials may be used as TMD materials.

The 2D semiconductor material may be doped with a p-type dopant or an n-type dopant to control mobility. In this case, as the p-type dopant and the n-type dopant, for example, a p-type dopant and an n-type dopant used for graphene or carbon nanotube (CNT) may be used. The p-type dopant or the n-type dopant may be doped by ion implantation or chemical doping.

Although the first channel layer 121 and the second channel layer 122 are illustrated, the number of channel layers is not limited to two. In another example, the multi bridge channel field effect transistor 100 may include three or more channel layers (e.g., 3 to 5, but not limited thereto).

The first graphene barrier GB1 may be provided on a side surface of the first source/drain pattern 180 facing the second source/drain pattern 190. The first graphene barrier GB1 may be interposed between the first source/drain pattern 180 and the first channel layer 121 and between the first source/drain pattern 180 and the second channel layer 122. The first graphene barrier GB1 may directly contact the first source/drain pattern 180, the first channel layer 121, and the second channel layer 122. The first graphene barrier GB1 may electrically connect the first source/drain pattern 180 and the first channel layer 121. The first source/drain pattern 180 and the first channel layer 121 may be apart from each other by the first graphene barrier GB1. The first graphene barrier GB1 may electrically connect the first source/drain pattern 180 and the second channel layer 122. The first source/drain pattern 180 and the second channel layer 122 may be apart from each other by the first graphene barrier GB1.

In an example, the first graphene barrier GB1 may include nanocrystalline graphene. Nanocrystalline graphene may be graphene including crystals that are smaller in size than intrinsic graphene, which is typical crystalline graphene. The nanocrystalline graphene may include crystals having a size of a nano-level, for example, about 0.5 nm to 100 nm. The ratio of carbon having an sp2 bond structure to the total carbon in the nanocrystalline graphene may be, for example, 50 % to 100 %. The nanocrystalline graphene may include, for example, hydrogen of about 1 atomic percent (at %) to about 20 at %. The density of the nanocrystalline graphene may be, for example, about 1.6 g/cc to about 2.1 g/cc, and the sheet resistance of the nanocrystalline graphene may be, for example, greater than about 1000 Ohm/sq. The first graphene barrier GB1 may prevent damage to the first source/drain pattern 180 when a sacrificial layer is removed in a manufacturing process of the multi bridge channel field effect transistor 100 to be described later below. The first graphene barrier GB1 may have a thickness of 0.34 nanometers (nm) to 2 nanometers (nm).

The second graphene barrier GB2 may be provided on a side surface of the first source/drain pattern 190 facing the second source/drain pattern 180. The second graphene barrier GB2 may be interposed between the second source/drain pattern 190 and the first channel layer 121 and between the second source/drain pattern 190 and the second channel layer 122. The second graphene barrier GB2 may directly contact the second source/drain pattern 190, the first channel layer 121, and the second channel layer 122. The second graphene barrier GB2 may electrically connect the second source/drain pattern 190 and the first channel layer 121. The second source/drain pattern 190 and the first channel layer 121 may be apart from each other by the first graphene barrier GB1. The second graphene barrier GB2 may electrically connect the second source/drain pattern 190 and the second channel layer 122. The second source/drain pattern 190 and the second channel layer 122 may be apart from each other by the first graphene barrier GB1. In an example, the second graphene barrier GB2 may include nanocrystalline graphene. The second graphene barrier GB2 may have a thickness of 0.34 nanometers (nm) to 2 nanometers (nm). The second graphene barrier GB2 may prevent damage to the second source/drain pattern 190 when a sacrificial layer is removed in a manufacturing process of the multi bridge channel field effect transistor 100 to be described later below.

The multi bridge channel field effect transistor 100 may have a multi-bridge shape in which the first channel layer 121 and the second channel layer 122 are in contact with the first graphene barrier GB1 and the second graphene barrier GB2, respectively, and are stacked to be apart from each other in a direction away from the substrate 110. Such a multi-bridge type channel may reduce a short channel effect and reduce the area occupied by a source/drain, so it is advantageous for high integration. In addition, because a uniform source/drain junction capacitance may be maintained regardless of the position of a channel, the multi-bridge type channel may have an advantage of being applied as a high-speed and high-reliability device. Although the multi bridge channel is illustrated as two channel layers, example embodiments are not limited thereto. The multi bridge channel field effect transistor 100 of the embodiment may include a plurality of channel layers stacked in three or more layers.

The gate insulating layer 140 may be provided between the first source/drain pattern 180 and the second source/drain pattern 190. The gate insulating layer 140 may cover surfaces of the first source/drain pattern 180, the second source/drain pattern 190, the first graphene barrier GB1, the second graphene barrier GB2, the first channel layer 121, and the second channel layer 122. The gate insulating layer 140 may surround the first channel layer 121 and the second channel layer 122. The gate insulating layer 140 may be provided on side surfaces of the first channel layer 121 and the second channel layer 122 extending in the first direction DR1. The gate insulating layer 140 may directly contact the first channel layer 121 and the second channel layer 122. The gate insulating layer 140 may include an insulating material. For example, the gate insulating layer 140 may include silicon oxide (e.g., SiO₂), silicon nitride (e.g., SiN), silicon oxynitride (e.g., SiON), a high-k material, or a ferroelectric material.

The high-k material may include, for example, aluminum oxide, hafnium oxide, zirconium hafnium oxide, lanthanum oxide, and the like.

The ferroelectric material has a spontaneous electric dipole, that is, spontaneous polarization because charge distribution in a unit cell is non-centrosymmetric in a crystallized material structure. Therefore, the ferroelectric material has remnant polarization due to a dipole even in the absence of an external electric field. In addition, a polarization direction of the ferroelectric material may be switched in domain units by applying an external electric field to the ferroelectric material. Such a ferroelectric material may include, for example, at least one oxide selected from Hf, aluminum (Al), Zr, yttrium (Y), lanthanum (La), gadolinium (Gd), and strontium (Sr), but example embodiments are not limit thereto. In addition, in some embodiments, the ferroelectric material may further include a dopant.

When the gate insulating layer 140 includes a ferroelectric material, the multi bridge channel field effect transistor 100 may be applied as, for example, a logic device or a memory device. When the gate insulating layer 140 includes a ferroelectric material, sub threshold swing (SS) may be lowered by a negative capacitance effect, so that the size of the multi bridge channel field effect transistor 100 may be reduced while improving performance.

The gate insulating layer 140 may have a multilayer structure including a high-k material and a ferroelectric material. The gate insulating layer 160 may include a charge trapping layer such as silicon nitride so that the multi bridge channel field effect transistor 100 may operate as a memory transistor having a memory characteristic.

The gate electrode 160 may be provided on side surfaces of the gate insulating layer 140 extending in the first direction DR1. The gate electrode 160 may surround the first channel layer 121 and the second channel layer 122 with the gate insulating layer 140 therebetween. Both ends of the gate electrode 160 in the first direction DR1 may contact the gate insulating layer 140. The gate electrode 160 may include a metal material or a conductive oxide. The metal material may include, for example, gold (Au), Ti, titanium nitride (TiN), tantalum nitride (TaN), W, Mo, tungsten nitride (WN), platinum (Pt), nickel (Ni), or a combination thereof. The conductive oxide may include, for example, indium tin oxide (ITO) or indium zinc oxide (IZO).

The multi bridge channel field effect transistor 100 may include the first graphene barrier GB1 and the second graphene barrier GB2 for reducing or preventing damage to the first source/drain pattern 180 and the second source/drain pattern 190.

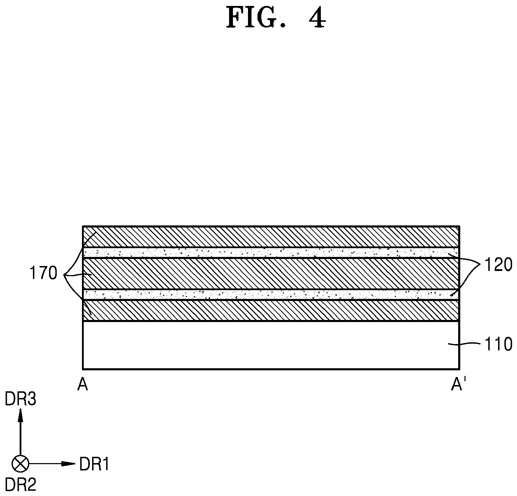

FIGS. 4 to 8 are cross-sectional views corresponding to the line A-A' of FIG. 1 for explaining a method of manufacturing the multi bridge channel field effect transistor of FIG. 1.

Referring to FIG. 4, the substrate 110 may be provided. The substrate 110 may be an insulating substrate or a semiconductor substrate having an insulating layer formed on its surface. The insulating substrate may be, for example, a glass substrate or a sapphire substrate. The semiconductor substrate may include, for example, Si, Ge, SiGe, or a group III-V semiconductor material.

A plurality of support layers 170 and a plurality of preliminary channel layers 120 may be alternately stacked on the substrate 110. The plurality of support layers 170 and the plurality of preliminary channel layers 120 may be formed by chemical vapor deposition (CVD) (e.g., metal organic CVD), physical vapor deposition (PVD), or atomic layer deposition (ALD). The plurality of support layers 170 may support the plurality of preliminary channel layers 120. The plurality of support layers 170 may be a sacrificial layer that is removed after another structure supporting the plurality of preliminary channel layers 120 is formed. The plurality of support layers 170 and the plurality of preliminary channel layers 120 may include materials having different etch ratios, respectively. For example, the plurality of support layers 170 may include SiGe, and the plurality of preliminary channel layers 120 may include Si or a 2D semiconductor material (e.g., graphene, black phosphorus, or TMD). When the plurality of preliminary channel layers 120 include a 2D semiconductor material, they may have a single-layer or a multi-layer structure. A thickness of the plurality of preliminary channel layers 120 may be 10 nm or less. The thickness of the plurality of preliminary channel layers 120 may be determined considering a length of a channel to be formed.

In an example, the plurality of preliminary channel layers 120 may include a 2D semiconductor material doped with a dopant of a certain conductivity type. The 2D semiconductor material of the plurality of preliminary channel layers 120 may be doped with a p-type dopant or an n-type dopant. In this case, as the p-type dopant and the n-type dopant, for example, a p-type dopant and an n-type dopant used for graphene or CNT may be used. The p-type dopant or the n-type dopant may be doped by ion implantation or chemical doping.

A source of a p-type dopant may include, for example, an ionic liquid such as NO₂BF₄, NOBF₄, or NO₂SbF₆, an acidic compound such as HCI, H₂PO₄, CH₃COOH, H₂SO₄, or HNO₃, and an organic compound such as dichlorodicyanoquinone (DDQ), oxone, dimyristoylphosphatidylinositol (DMPI), or trifluoromethanesulfoneimide. Alternatively, the source of the p-type dopant may include HPtCl₄, AuCl₃, HAuCl₄, silver trifluoromethanesulfonate (AgOTf), AgNO₃, H₂PdCl₆, Pd(OAc)₂, or Cu(CN)₂.

A source of an n-type dopant may include, for example, a reduction product of a substituted or unsubstituted nicotinamide, a reduction product of a compound which is chemically bonded to the substituted or unsubstituted nicotinamide, and a compound comprising at least two pyridinium moieties in which a nitrogen atom of at least one of the pyridinium moieties is reduced. For example, the source of the n-type dopant may include nicotinamide mononucleotide-H (NMNH), nicotinamide adenine dinucleotide-H (NADH), nicotinamide adenine dinucleotide phosphate-H (NADPH), or viologen. Alternatively, the source of the n-type dopant may include a polymer such as polyethylenimine (PEI). Alternatively, the n-type dopant may include alkali metal such as potassium (K) or lithium (Li). Meanwhile, materials of the p-type dopant and the n-type dopant are merely examples, and various materials may be used as a dopant.

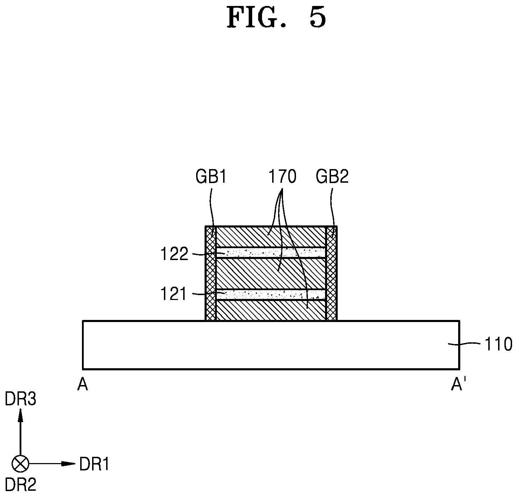

Referring to FIG. 5, a structure in which the plurality of support layers 170 and the plurality of preliminary channel layers 120 are alternately stacked (hereinafter referred to as stacked structure) may be patterned. For example, patterning a stacked structure may include forming a mask pattern (not shown) on the stacked structure and etching the stacked structure using a mask pattern. For example, etching a stacked structure may include performing an anisotropic dry etching process. The plurality of preliminary channel layers 120 may be patterned to form the first channel layer 121 and the second channel layer 122.

The first graphene barrier GB1 and the second graphene barrier GB2 may be respectively formed on both sides of the patterned stacked structure. For example, the first graphene barrier GB1 and the second graphene barrier GB2 may be formed using a CVD or ALD process. The first graphene barrier GB1 and the second graphene barrier GB2 may cover side surfaces of the plurality of support layers 170, the first channel layer 121, and the second channel layer 122. After the first graphene barrier GB1 and the second graphene barrier GB2 are formed, the mask pattern may be removed.

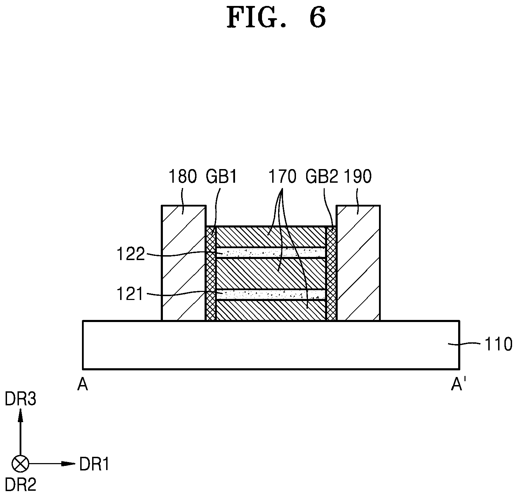

Referring to FIG. 6, the first source/drain pattern 180 and the second source/drain pattern 190 may be formed. For example, the first source/drain pattern 180 and the second source/drain pattern 190 may be formed by an epitaxial growth process. In an example, a pair of seed patterns (not shown) for growing the first source/drain pattern 180 and the second source/drain pattern 190 may be formed on the substrate 110 before forming the first source/drain pattern 180 and the second source/drain pattern 190. The first source/drain pattern 180 and the second source/drain pattern 190 may include SiGe. The first source/drain pattern 180 and the second source/drain pattern 190 may directly contact the first graphene barrier GB1 and the second graphene barrier GB2, respectively.

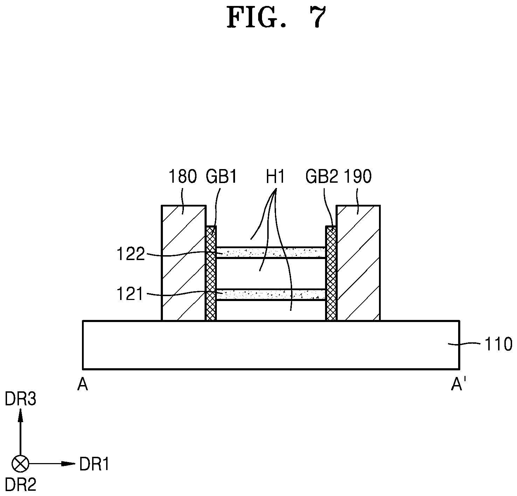

Referring to FIG. 7, the plurality of support layers 170 may be removed. The plurality of support layers 170 may be removed by a wet etching process or a dry etching process. An etching solution or etching gas used for selectively removing the plurality of support layers 170 may have a faster etching rate with respect to the plurality of support layers 170, but may have a slower etching rate with respect to the first channel layer 121 and the second channel layer 122. In other words, the etching solution or etching gas used for selectively removing the plurality of support layers 170 may have a larger etching selectivity with respect to the plurality of support layers 170 and the first channel layer 121 and the second channel layer 122. Removing the plurality of support layers 170 may be performed until the plurality of support layers 170 are completely removed. After the plurality of support layers 170 are removed, the first channel layer 121 and the second channel layer 122 may be exposed by a first space H1. The first space H1 may be an area generated by removing the plurality of support layers 170. Accordingly, a structure in which the first channel layer 121 and the second channel layer 122 are supported in a bridge form may be formed between the first graphene barrier GB1 and the second graphene barrier GB2.

When the first source/drain pattern 180 and the second source/drain pattern 190 include the same material as that of the plurality of support layers 170, the first source/drain pattern 180 and the second source/drain pattern 190 may be damaged when removing the plurality of support layers 170. For example, a portion of the first source/drain pattern 180 and the second source/drain pattern 190 may be removed. When the first source/drain pattern 180 and the second source/drain pattern 190 are damaged, the multi bridge channel field effect transistor 100 may not have desired and/or required characteristics.

In example embodiments, by arranging the first graphene barrier GB1 between the first source/drain pattern 180 and the plurality of support layers 170 and arranging the second graphene barrier GB2 between the second source/drain pattern 190 and the plurality of support layers 170, damage to the first source/drain pattern 180 and the second source/drain pattern 190 may be reduced or prevented when removing the plurality of support layers 170.

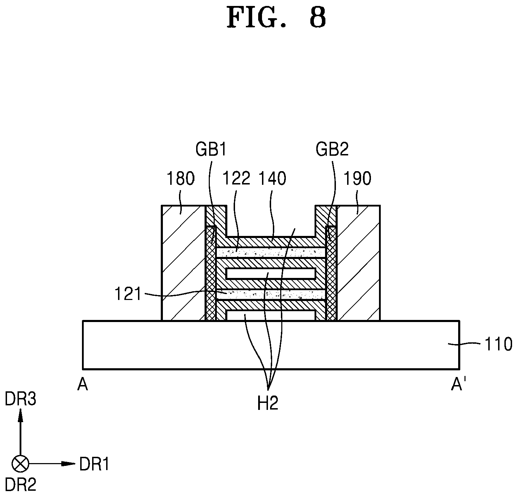

Referring to FIG. 8, the gate insulating layer 140 may be formed between the first source/drain pattern 180 and the second source/drain pattern 190. The gate insulating layer 140 may cover surfaces of the first source/drain pattern 180, the second source/drain pattern 190, the first graphene barrier GB1, the second graphene barrier GB2, the first channel layer 121, and the second channel layer 122. The gate insulating layer 140 may surround the first channel layer 121 and the second channel layer 122. The forming of the gate insulating layer 140 may include performing CVD, ALD, and PVD processes. In an example, the gate insulating layer 140 may conformally extend on surfaces of the first source/drain pattern 180, the second source/drain pattern 190, the first graphene barrier GB1, the second graphene barrier GB2, the first channel layer 121, and the second channel layer 122. The deposition process of the gate insulating layer 140 may be performed so that the gate insulating layer 140 fills a portion of the first space H1. An area not filled by the gate insulating layer 140 may be referred to as a second space H2. The gate insulating layer 140 may include an insulating material. For example, the gate insulating layer 140 may include silicon oxide (e.g., SiO₂), silicon nitride (e.g., SiN), silicon oxynitride (e.g., SiON), a high-k material, or a ferroelectric material.

Referring back to FIG. 2, the gate electrode 160 may be formed in the second space H2. The second space H2 may be filled with the gate electrode 160. Accordingly, the gate electrode 160 may surround the first channel layer 121 and the second channel layer 122 with the gate insulating layer 140 therebetween. The forming of the gate electrode 160 may include performing CVD, ALD, and PVD processes. The gate electrode 160 may include a metal material or a conductive oxide. The metal material may include, for example, Au, Ti, TiN, TaN, W, Mo, WN, Pt, Ni, or a combination thereof. The conductive oxide may include, for example, ITO or IZO.

The disclosure may provide a method of manufacturing a multi bridge channel field effect transistor for reducing or preventing damage to the first source/drain pattern 180 and the second source/drain pattern 190 by using the first graphene barrier GB1 and the second graphene barrier GB2.

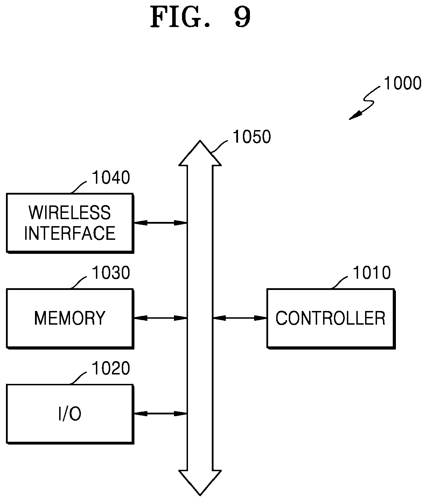

FIG. 9 is a block diagram of an electronic device including a multi bridge channel field effect transistor according to an embodiment.

The electronic device 1000 may include a controller 1010, an input/output device (I/O) 1020, a memory 1030, and a wireless interface 1040, which may be interconnected to each other via a bus 1050.

The controller 1010 may include at least one of a microprocessor, a digital signal processor, or a processing device similar thereto. The I/O device 1020 may include at least one of a keypad, a keyboard, and a display. The memory 1030 may be used to store instructions executed by controller 1010. For example, the memory 1030 may be used to store user data. The electronic device 1000 may use the wireless interface 1040 to transmit/receive data via a wireless communication network. The wireless interface 1040 may include an antenna and/or a wireless transceiver. In some embodiments, the electronic device 1000 may be used in a communication interface protocol. The memory 1030 may include the multi bridge channel field effect transistor described above in FIGS. 1 to 3. The memory may include an array having a plurality of the multi bridge channel field effect transistors described above in FIGS. 1 to 3.

The disclosure may provide a multi bridge channel field effect transistor including a graphene barrier.

The disclosure may provide a method of manufacturing a multi bridge channel field effect transistor including a graphene barrier.

The disclosure may provide an electronic device including a memory with a multi bridge channel field effect transistor including a graphene barrier.

However, example embodiments are not limited thereto.

One or more of the elements disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of inventive concepts as defined by the following claims.

## Claims

1. A multi bridge channel field effect transistor comprising:
a substrate;
a first source/drain pattern on the substrate;
a second source/drain pattern apart from the first source/drain pattern in a first direction on the substrate;
a first channel layer and a second channel layer between the first source/drain pattern and the second source/drain pattern;
a first graphene barrier between the first channel layer and the first source/drain pattern;
a gate insulating layer surrounding the first channel layer; and
a gate electrode surrounding the first channel layer with the gate insulating layer therebetween.

2. The multi bridge channel field effect transistor of claim 1,
wherein the first graphene barrier extends to an area between the second channel layer and the first source/drain pattern.

3. The multi bridge channel field effect transistor of claim 1 or 2, further comprising:
a second graphene barrier between the first channel layer and the second source/drain pattern.

4. The multi bridge channel field effect transistor of claim 3,
wherein the second graphene barrier extends to an area between the second channel layer and the second source/drain pattern,
and optionally wherein the gate insulating layer extends along a surface of the first graphene barrier, a surface of the second graphene barrier, a surface of the first channel layer, and a surface of the second channel layer.

5. The multi bridge channel field effect transistor of any preceding claim,
wherein the first source/drain pattern and the second source/drain pattern each includes silicon germanium, SiGe.

6. The multi bridge channel field effect transistor of any preceding claim,
wherein the first channel layer and the second channel layer are arranged in a direction substantially perpendicular to an upper surface of the substrate.

7. The multi bridge channel field effect transistor of any preceding claim, wherein the first graphene barrier includes nanocrystalline graphene.

8. A method of manufacturing a multi bridge channel field effect transistor, the method comprising:
forming a stacked structure including a plurality of support layers and a plurality of channel layers alternately stacked on a substrate;
forming a first graphene barrier on one side of the stacked structure;
forming a first source/drain pattern on an opposite side of the stacked structure with respect to the first graphene barrier;
selectively removing the plurality of support layers to expose the plurality of channel layers;
forming a gate insulating layer on surfaces of the plurality of channel layers; and
forming a gate electrode on a surface of the gate insulating layer.

9. The method of claim 8, wherein the selectively removing the plurality of support layers includes a wet etching process using an etching solution or a dry etching process using an etching gas, and
the first graphene barrier is configured to prevent the etching solution or the etching gas from contacting the first source/drain pattern during the selectively removing the plurality of support layers.

10. The method of claim 9, further comprising:
forming a second graphene barrier on the other side of the stacked structure opposite the one side of the stacked structure; and
forming a second source/drain pattern on the substrate, wherein
the second graphene barrier layer extends between the second source/drain pattern and the stacked structure, and
the second graphene barrier is configured to prevent the etching solution or the etching gas from contacting the second source/drain pattern during the selectively removing the plurality of support layers.

11. The method of claim 8, 9 or 10, further comprising:
forming the gate insulating layer on a surface of the first graphene barrier during the forming the gate insulating layer.

12. The method of any of claims 8 to 11,
wherein the forming the first graphene barrier includes performing a chemical vapor deposition process or an atomic layer deposition process.

13. The method of any of claims 8 to 12,
wherein the first source/drain pattern and the plurality of channel layers are separated from each other by the first graphene barrier.

14. The method of any of claims 8 to 13,
wherein the first source/drain pattern and the plurality of support layers each include silicon germanium (SiGe).

15. The method of any of claims 8 to 14,
wherein the first graphene barrier includes nanocrystalline graphene.
